# EUROPÄISCHE PATENTSCHRIFT

(11) **EP 3 121 860 B1**
(45) Veröffentlichungstag und Bekanntmachung des Hinweises auf die Patenterteilung: **25.11.2020**
(21) Anmeldenummer: 15306183.3
(22) Anmeldetag: 21.07.2015
(51) Int. Cl.: H01L 39/16

(54) **ANORDNUNG ZUR STROMBEGRENZUNG IN EINEM DER STROMVERSORGUNG DIENENDEN NETZWERK**
SYSTEM FOR LIMITING ENERGY IN A POWER SUPPLY NETWORK
SYSTEME DE LIMITATION DE COURANT DANS UN RESEAU SERVANT A L'ALIMENTATION ELECTRIQUE

(43) Veröffentlichungstag der Anmeldung: 25.01.2017
(73) Patentinhaber: Nexans, 92400 Courbevoie (FR)
(72) Erfinder: STEMMLE, Mark, 30175 Hannover (DE); WEST, Beate, 30169 Hannover (DE)
(74) Vertreter: Ipsilon

(56) Entgegenhaltungen:
- WO-A1-99/33122
- WO-A1-2014/126006
- DD-A1- 110 985
- DE-A1- 19 832 274
- US-A1- 2013 255 991

## Beschreibung

Die Erfindung bezieht sich auf ein dreiphasiges, der Stromversorgung dienendes Netzwerk entsprechend dem Oberbegriff des Patentanspruchs 1.

Eine solche Anordnung ist bekannt und beispielsweise in den Druckschriften EP 0 503 448 A2, DE 10 2004 048 646 B4 und DE 10 2006 029 722 B3 beschrieben. Sie dient dazu, die Auswirkungen von Kurzschlüssen in der Stromversorgung dienenden Netzwerken zu vermeiden. Dabei werden die Eigenschaften von supraleitfähigen Materialien ausgenutzt, die bei ausreichend tiefen Temperaturen supraleitfähig werden und bei Überschreiten einer bestimmten Stromstärke, der kritischen Stromstärke, schlagartig in den normalleitenden Zustand übergehen. Der elektrische Gleichstromwiderstand eines supraleitfähigen Leiters ist bei ausreichender Kühlung Null, solange die kritische Stromstärke nicht überschritten wird. Geeignete Materialien sind beispielsweise oxidische Materialien auf Basis seltener Erden (ReBCO), insbesondere YBCO (Yttrium-Barium-Kupfer-Oxid) oder BSCCO (Wismut-Strontium-Kalzium-Kupfer-Oxid). Ausreichend niedrige Temperaturen, um ein derartiges Material in den supraleitfähigen Zustand zu bringen, liegen beispielsweise zwischen 67 K und 110 K.

Beim Auftreten eines Kurzschlussstromes wird die kritische Stromstärke eines supraleitfähigen Leiters überschritten, womit der Übergang vom supraleitfähigen Zustand, mit einem vernachlässigbar kleinen elektrischen Widerstand des Materials, in den normalleitenden Zustand, mit einem sehr hohen elektrischen Widerstand des Materials, einhergeht. Darüber hinaus erwärmt sich das Material im normalleitenden Zustand durch dessen ohmsche Verluste und der elektrische Widerstand steigt weiter an. Der Übergang des Materials vom supraleitenden in den normalleitenden Zustand geschieht beim Überschreiten der kritischen Stromstärke sehr schnell, typischerweise im Bereich von wenigen Millisekunden. Dadurch wird bei Einsatz einer der bekannten Anordnungen schnell ein elektrischer Widerstand in das Netzwerk eingeschaltet, welcher den Kurzschlussstrom begrenzt. Das Netzwerk und die Anordnung selbst werden dadurch gegenüber einem hohen Kurzschlussstrom geschützt.

Die bekannten Anordnungen nach den im Vorangehenden erwähnten Druckschriften weisen supraleitfähige Leiter auf, die mit bifilarem Aufbau auf scheibenförmigen Trägern angeordnet sind. In Abhängigkeit von der benötigten Leiterlänge ist eine geeignete Anzahl solcher Träger in einem als Kryostat wirkenden Gehäuse angeordnet. Für jede Phase eines Wechselstromnetzes wird in Montageposition ein solcher Kryostat eingesetzt. Die Herstellung der mit bifilar angeordneten supraleitfähigen Leitern bestückten Träger ist aufwendig. Da für jede Phase des Wechselstromnetzes ein entsprechend aufgebauter Kryostat verwendet wird, ist der Platzbedarf für deren Aufbau relativ groß, insbesondere dann, wenn es sich um ein dreiphasiges Wechselstrom netz handelt.

Aus der WO 2014/126006 A1 (EP 2 945 199 A1) geht ebenfalls ein supraleitfähiger Strombegrenzer hervor. In dieser Druckschrift ist ein Träger dargestellt, auf dem sechs supraleitfähige Elemente mit spiralförmigem Verlauf angeordnet sind. Es ist auch eine Reihenschaltung von Komponenten mit mehreren parallelgeschalteten einphasigen Elementen dargestellt.

Weiterhin betrifft die US 2013/0255991 A1 die Verwendung von supraleitfähigen elektrischen Leitern in Starkstromkabeln. Es wird ein Aufbau für solche Kabel angegeben, die flexibler sind und geringere Verluste im Verhältnis zu konventionellen Kabeln haben. Diese Verluste sind mit Wechselstromverlusten, Wirbelstromverlusten und Hystereseverlusten angeben. Das Starkstromkabel dient zur Verbindung einer Spannungsquelle mit einem Gerät. Es weist eine Anzahl von supraleitfähigen Leitern auf, die in Bündeln angeordnet sind. Jedes Bündel hat drei voneinander getrennte elektrische Leiter, die in einer niedrige Verluste bewirkenden Konfiguration zusammengefaßt sind.

Außerdem sind der WO 99/33122 A1 ein Supraleiteraufbau und eine Strombegrenzereinrichtung mit einem solchen Aufbau zu entnehmen. Dieser Aufbau besteht aus einem bandförmigen Träger aus Metall, einer Zwischenschicht und einer supraleitfähigen Schicht. In einem entsprechenden Begrener sind zwei an einem gemeinsamen Ende elektrisch miteinander verbundene Bandleiter zu einem bifilaren Scheibenwickel verbunden. Mehrere solcher modulartigen Scheibenwickel können zu einer einphasigen Strombegrenzereinrichtung zusammengebaut werden.

Die DE 198 32 274 beschreibt einen einphasigen Strombegrenzer mit einer supraleitfähigen Leiterbahnstruktur, die durch eine mäanderförmige Leiterbahn gebildet ist. Diese eine Leiterbahn umfaßt geradlinige und bogenförmig gestaltete Leiterbahnabschnitte. Mit diesem mäanderförmigen Verlauf der Leiterbahn sollen Knickstellen im Verlauf des Leiters vermieden werden.

Der Erfindung liegt die Aufgabe zugrunde, die eingangs geschilderte Anordnung sowohl im Aufbau als auch in der Handhabung zu vereinfachen.

Diese Aufgabe wird entsprechend den kennzeichnenden Merkmalen des Patentanspruchs 1 gelöst.

Diese Anordnung ist als kompakte, einteilige Einheit direkt an ein dreiphasiges Wechselstrom netz anschließbar, und zwar über zwei elektrische Kontaktstellen für jeden Phasenleiter der Anordnung. Die Fertigung der Anordnung ist relativ einfach, weil die drei Phasenleiter derselben nur in spiralförmigen Windungen parallel zueinander auf dem jeweiligen Träger angeordnet werden müssen. Sie können an ihren Enden gegebenenfalls einfach mit auf weiteren Trägern angeordneten Phasenleitern verbunden werden. Dazu reichen einfache Verbindungsleiter aus, die zwischen den Enden der Phasenleiter eines Trägers und den Anfängen der Phasenleiter eines weiteren Trägers angeschlossen werden. Die Anordnung kann unabhängig von der Anzahl der mit Phasenleitern bestückten Träger in nur einen, als Kryostat ausgebildeten Behälter eingebaut werden, der mit wenig Aufwand zum Montageort transportiert und dort mit gegenüber den bekannten Anordnungen vermindertem Platzbedarf aufgestellt werden kann. Da alle benötigten supraleitfähigen Phasenleiter in nur einem Kryostat untergebracht sind, wird für die Anordnung insgesamt weniger Material zur Fixierung des supraleitfähigen Materials benötigt.

Zwischen den Phasenleitern jedes Trägers können mit Vorteil spannungsfeste Abstandshalter angeordnet sein, die vorzugsweise aus glasfaserverstärktem Kunststoff bestehen.

Ein Ausführungsbeispiel des Erfindungsgegenstandes ist in den Zeichnungen dargestellt.

Es zeigen:
Fig. 1 eine Draufsicht auf eine Anordnung nach der Erfindung in schematischer Darstellung.
Fig. 2 eine Seitenansicht der Anordnung nach Fig. 1.
Fig. 3 mehrere in einem Behälter angeordnete Anordnungen nach Fig. 1.

Auf einem plattenartigen Träger 1 aus einem mechanisch stabilen Kunststoff, wie beispielsweise glasfaserverstärkter Kunststoff, sind drei supraleitfähige Phasenleiter 2, 3 und 4 angeordnet und auf demselben befestigt. Die Phasenleiter 2, 3 und 4 verlaufen in spiralförmigen Windungen parallel zueinander. Sie sind auf der Oberfläche des Trägers 1 so angeordnet, daß dieselbe im Wesentlichen bedeckt ist. An den Enden der Phasenleiter 2, 3 und 4 sind mit Vorteil Kontaktelemente 5 einerseits und 6 andererseits angebracht.

Zwischen den Windungen der Phasenleitern 2, 3 und 4 können als Isoliermedium entsprechend dem dargestellten Ausführungsbeispiel spannungsfeste Abstandshalter 7, 8 und 9 angeordnet sein, die durch Kreuze und Striche sowie Kreise als unterschiedliche Teile angedeutet sind. Sie bestehen beispielsweise aus glasfaserverstärktem Kunststoff. Jeder der Phasenleiter 2, 3 und 4 kann aber auch von elektrischem Isoliermaterial umgeben sein.

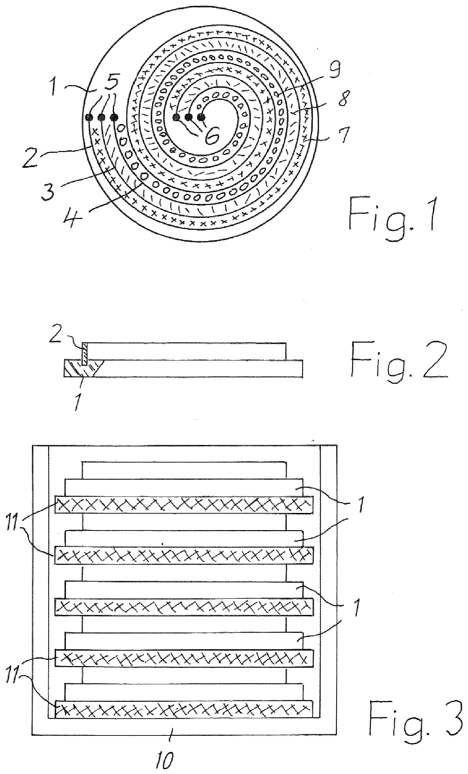

Jeder Phasenleiter 2, 3 oder 4 weist einen supraleitfähigen Leiter auf, der mit Vorteil als Band ausgeführt und hochkant auf dem jeweiligen Träger 1 angeordnet sein kann. Dazu bietet sich beispielsweise für jeden Phasenleiter eine im Träger 1 angebrachte Nut an, die in den vorgesehenen spiralförmigen Windungen verläuft und in die der jeweilige Leiter eingreift. Das geht schematisch aus Fig. 2 hervor. Bei derart auf dem jeweiligen Träger 1 fixierten Phasenleitern 2, 3 und 4 kann als Isoliermedium beispielsweise auch ein Kühlmedium, beispielsweise flüssiger Stickstoff, eingesetzt werden, das in einem Kryostat vorhanden ist, in den innerhalb der fertiggestellten Anordnung mindestens ein entsprechend den vorangehenden Erläuterungen bestückter Träger 1 eingesetzt ist.

Um eine für den jeweiligen Anwendungsfall ausreichende Länge der Phasenleiter 2, 3 und 4 zu erhalten, wird mit Vorteil eine ausreichende Anzahl von Anordnungen nach den Fig. 1 und 2 elektrisch in Reihe geschaltet. Dazu können Anordnungen nach Fig. 2 beispielsweise übereinander liegend in einem Behälter 10 angeordnet werden, welcher vakuumisoliert und damit als Kryostat ausgeführt ist. In Fig. 3 sind in dem Behälter 10 fünf Anordnungen nach Fig. 2 eingezeichnet, die durch Zwischenlagen 11 voneinander getrennt sind.

Ein beispielsweise nach Fig. 3 aufgebauter Behälter 10 bzw. Kryostat kann zum Montageort transportiert und dort an ein dreiphasiges Wechselstromnetz angeschlossen werden. Die Phasenleiter 2, 3 und 4 werden dann vor Inbetriebnahme auf eine Temperatur abgekühlt, bei der das supraleitfähige Material in den supraleitfähigen Zustand übergeht.

## Patentansprüche

1. Dreiphasiges, der Stromversorgung dienendes Netzwerk, das eine Anordnung zur Strombegrenzung umfaßt, welche zur Integration in dem Netzwerk geeignet ist und welche supraleitfähige Leiter aufweist, die auf mindestens einem plattenartigen Träger aus Isoliermaterial angebracht sind, **dadurch gekennzeichnet,**
- **dass** auf dem mindestens einen Träger (1) drei voneinander getrennte, in spiralförmigen Windungen parallel zueinander verlaufende supraleitfähige Phasenleiter (2,3,4) zum getrennten Anschluß an die Phasen des dreiphasigen, der Stromversorgung dienenden Netzwerks angeordnet und jeweils an die Phasen des dreiphasigen, der Stromversorgung dienenden Netzwerks angeschlossen sind und
- **dass** der mindestens eine, mit drei voneinander getrennten Phasenleitern (2,3,4) bestückte Träger (1) in einem als Kryostat ausgebildeten Behälter eingebaut ist.

2. Dreiphasiges, der Stromversorgung dienendes Netzwerk nach Anspruch 1, **dadurch gekennzeichnet, dass** zwischen den drei Phasenleitern (2,3,4) jeweils spannungsfeste Abstandshalter (7,8,9) angebracht sind.

3. Dreiphasiges, der Stromversorgung dienendes Netzwerk nach Anspruch 1, **dadurch gekennzeichnet,**
- **dass** die Phasenleiter (2,3,4) mit ihren spiralförmigen Windungen auf dem mindestens einen Träger (1) fixiert sind und
- **dass** ein Kühlmedium, vorzugsweise flüssiger Stickstoff, als Isoliermedium zwischen den Phasenleitern (2,3,4) angeordnet ist.

4. Dreiphasiges, der Stromversorgung dienendes Netzwerk nach Anspruch 1, **dadurch gekennzeichnet, dass** jeder der Phasenleiter (2,3,4) von elektrischem Isoliermaterial umgeben ist.

## Claims

1. A three-phase network serving to supply power, which comprises an arrangement for limiting the power, which is suitable for integration in the network and which has superconductive conductors, which are mounted on at least one plate-like carrier made of insulating material, **characterized in**
- **that** on the at least one carrier (1) three separate from one another superconductive phase conductors (2, 3, 4) running in spiral-shaped windings parallel to one another are arranged for separate connection to the phases of the three-phase network serving to supply power and in each case are connected to the phases of the three-phase network serving to supply power and
- **that** the at least one carrier (1) equipped with three separate from one another phase conductors (2, 3, 4) is installed in a container designed as a cryostat.

2. The three-phase network serving to supply power according to claim 1, **characterized in that** in each case voltage-resistant spacers (7, 8, 9) are mounted between the three phase conductors (2, 3, 4).

3. The three-phase network serving to supply power according to claim 1, **characterized in**
- **that** the phase conductors (2, 3, 4) are fixed with their spiral-shaped windings on the at least one carrier (1) and
- **that** a coolant, preferably liquid nitrogen, is arranged as an insulating medium between the phase conductors (2, 3, 4).

4. The three-phase network serving to supply power according to claim 1, **characterized in that** each of the phase conductors (2, 3, 4) is surrounded by electrical insulating material.

## Revendications

1. Réseau triphasé permettant une alimentation électrique, qui comprend un dispositif pour la limitation du courant, qui est adapté à une intégration dans le réseau et qui comprend des conducteurs supraconducteurs qui sont montés sur au moins un support en forme de plaque en matériau isolant, **caractérisé en ce que**
- sur l'au moins un support (1) sont disposés trois conducteurs de phase supraconducteurs (2, 3, 4) séparés, s'étendant parallèlement entre eux avec des enroulements en spirale, pour le raccordement séparé aux phases du réseau triphasé permettant une alimentation électrique et sont raccordés à chacune des phases du réseau triphasé permettant une alimentation électrique et
- l'au moins un support (1) muni de trois conducteurs de phase supraconducteurs (2, 3, 4) séparés les uns des autres est intégré dans un récipient conçu comme un cryostat.

2. Réseau triphasé permettant une alimentation électrique selon la revendication 1, **caractérisé en ce que**, entre les trois conducteurs de phase (2, 3, 4) sont montées dans chaque cas des entretoises (7, 8, 9) résistant à la tension.

3. Réseau triphasé permettant une alimentation électrique selon la revendication 1, **caractérisé en ce que**
- les conducteurs de phase (2, 3, 4) sont fixés avec leurs enroulements en spirale sur l'au moins un support (1) et
- un fluide de refroidissement, de préférence de l'azote liquide, est disposé en tant que milieu isolant entre les conducteurs de phase (2, 3, 4).

4. Réseau triphasé permettant une alimentation électrique selon la revendication 1, **caractérisé en ce que** chacun des conducteurs de phase (2, 3, 4) est entouré d'un matériau électriquement isolant.
